# EUROPEAN PATENT APPLICATION

(11) **EP 2 541 673 A1**
(43) Date of publication of application: **02.01.2013**
(21) Application number: 11747056.7
(22) Date of filing: 24.02.2011
(51) Int. Cl.: H01M 14/00, H01L 31/04

(54) **APPARATUS FOR MANUFACTURING DYE-SENSITIZED SOLAR CELL, AND METHOD OF MANUFACTURING DYE-SENSITIZED SOLAR CELL**

(30) Priority: 25.02.2010 JP 2010039846
(71) Applicant: Tokyo Electron Limited, Tokyo 107-6325 (JP); Kyushu Institute of Technology, Kitakyushu-shi, Fukuoka 804-8550 (JP)
(72) Inventor: HAYASHI, Hiroaki, Tokyo 107-6325 (JP); SHIRATSUCHI, Ryuichi, Kitakyushu-shi Fukuoka 804-8550 (JP); OHKUBO, Suehiro, Kitakyushu-shi Fukuoka 804-8550 (JP); HAYASE, Shuzi, Kitakyushu-shi Fukuoka 808-0196 (JP); MURE, Taiichi, Kitakyushu-shi Fukuoka 804-8550 (JP); SHISHIDA, Yasuhiro, Kitakyushu-shi Fukuoka 804-8550 (JP)
(74) Representative: Diehl & Partner GbR
(86) International application number: PCT/JP2011/001069
(87) International publication number: WO 2011/105089

(57) **Abstract**

An apparatus for manufacturing a dye-sensitized solar cell is disclosed. The dye-sensitized solar cell is configured for photosensitization dye solution to come in contact with an electrode material layer that functions as a working electrode of a dye-sensitized solar cell. Further, the dye-sensitized solar cell is configured for the photosensitization dye to be adsorbed by the electrode material layer. Such apparatus includes a substrate housing part configured to house a substrate with the electrode material layer formed on the surface thereof, and a circulation mechanism configured to circulate the photosensitization dye solution to pass over the surface of the substrate housed within the substrate housing part. The cross section of the flowing path of the photosensitization dye solution at a section that faces the substrate is configured to be narrower than the cross sections of the flowing paths of the photosensitization dye solution at the other sections.

## Description

### TECHNICAL FIELD

The present disclosure relates to an apparatus and method for manufacturing a dye-sensitized solar cell.

### BACKGROUND

In recent years, a dye-sensitized solar cell using a single crystalline silicon semiconductor, a poly crystalline silicon semiconductor or an amorphous silicon semiconductor, has been employed in the application of electronic products such as a calculator, or a household use. However, to manufacture the dye-sensitized solar cell using such a silicon semiconductor, a high precision process including a plasma CVD, a high temperature crystal growth process or the like is required. Further, such process requires a substantial amount of energy and an expensive equipment for producing a vacuum, which increase the manufacturing cost of the dye-sensitized solar cell.

To address such concerns, there has been proposed a dye-sensitized solar cell as a solar cell which can be manufactured at a low cost under normal pressure and atmosphere. A dye-sensitized solar cell is generally configured to include: a transparent conductive thin film formed on one surface of a transparent substrate; a working electrode having a porous metal oxide semiconductor layer made of particles adsorbed with a dye, which is formed on a surface of the transparent conductive thin film; a counter electrode made of a catalyst (e.g., a conductive substrate having platinum or carbon), which faces the working electrode; and an electrolyte between the working electrode and the counter electrode. Metal complex-based dyes including metal such as Ru or metal-free organic dyes are used as a photosensitizing dye.

A process in which a dye is adsorbed onto a porous metal oxide semiconductor layer is performed for about a half day in a dye-dissolved solution in a dark place under atmospheric pressure. Accordingly, in order to more efficiently produce the dye-sensitized solar cell in a short time, it is required to increase speed of performing the dye adsorption process.

Several attempts have been made to decrease the time for performing the dye adsorption process. For example, a substrate having a film made of porous metal oxide semiconductor particles may be dipped in a dye solution such as a pressurized fluid comprising carbon dioxide under temperature and pressure conditions where supercritical carbon dioxide fluid may be formed in which Ru-complex (one of metal complexes) is dissolved. In this method, once the substrate is dipped in the dye solution for 30 minutes, the film of the substrate absorbs the dye so that the film has a photoelectric conversion efficiency higher than that of film obtained from the conventional dipping technique *(see* Patent Document 1).

### [Prior Art Documents]

### Patent Document

Patent Document 1: Japanese laid-open publication No. 2008-071535

Although a dye made of a Ru-complex has high photoelectric conversion efficiency, it requires a long adsorption time. A dye dissolved in a pressurized fluid comprising supercritical carbon dioxide fluid may be adsorbed on the surface of a porous body made of oxide semiconductor particles within a very short time (i.e., about 30 minutes). However, in order to obtain the pressurized fluid, it is required to use a dye adsorption device including a large-sized pressure vessel capable of enduring a pressure of about 100 atmospheres. Thus, adding such a pressure performance to a large cell production equipment raises the cost of the equipment, and does not reduce the production cost which is required for a dye-sensitized solar cell industry.

Accordingly, there is a need to develop a method and device for adsorbing a dye within a short time without using a high pressure of about 100 atmosphere, which speeds up a production process of a dye-sensitized solar cell at a low cost, and enhances a photoelectric conversion efficiency of the dye-sensitized solar cell produced in a system comprising the dye adsorption process.

The present disclosure has been made considering the above circumstances, and provides some embodiments of an apparatus and method for manufacturing a dye-sensitized solar cell, which can speed up a production process of a dye-sensitized solar cell at a low cost, and enhance a photoelectric conversion efficiency of the dye-sensitized solar cell produced in a system comprising the dye adsorption process.

### SUMMARY

According to one embodiment of the present disclosure, there is provided an apparatus for manufacturing a dye-sensitized solar cell is disclosed. The dye-sensitized solar cell is configured for photosensitization dye solution to come in contact with an electrode material layer that functions as a working electrode of a dye-sensitized solar cell. Further, the dye-sensitized solar cell is configured for the photosensitization dye to be adsorbed by the electrode material layer. Such apparatus includes a substrate housing part formed in a sealing vessel shape and configured to house a substrate with the electrode material layer formed on the surface thereof, and a circulation mechanism configured to circulate the photosensitization dye solution to pass over the surface of the substrate housed within the substrate housing part. The cross section of the flowing path of the photosensitization dye solution at a section that faces the substrate is configured to be narrower than the cross sections of the flowing paths of the photosensitization dye solution at the other sections.

According to another embodiment of the present disclosure, there is provided a method for manufacturing a dye-sensitized solar cell is disclosed. The dye-sensitized solar cell is configured for photosensitization dye solution to come in contact with an electrode material layer that functions as a working electrode of a dye-sensitized solar cell. Further, the dye-sensitized solar cell is configured for the photosensitization dye to be adsorbed by the electrode material layer. Such method includes housing, via a substrate housing part formed in a sealing vessel shape, a substrate with the electrode material layer formed on the surface thereof, and circulating the photosensitizing dye solution through a flow path which is formed between the surface of the substrate housed within the substrate housing part and a facing surface of the substrate housing part which faces the surface of the substrate.

### EFFECTS OF THE PRESENT DISCLOSURE

According to the present disclosure, it is possible to provide an apparatus and method for manufacturing a dye-sensitized solar cell, which can speed up a production process of a dye-sensitized solar cell at a low cost, and enhance a photoelectric conversion efficiency of the dye-sensitized solar cell produced in a system comprising the dye adsorption process.

### BRIEF DESCRIPTION OF THE DRAWINGS

**FIG. 1** is a view illustrating the configuration of a photosensitizing dye adsorption device according to one embodiment of the present disclosure.
**FIG. 2** is a view illustrating configurations of major parts of the photosensitizing dye adsorption device shown in **FIG. 1****.**
**FIG. 3** is a view illustrating configurations of major parts of the photosensitizing dye adsorption device shown in **FIG. 1****.**
**FIG. 4** is a view illustrating configurations of major parts of the photosensitizing dye adsorption device shown in **FIG. 1****.**
**FIG. 5** is a view illustrating the configuration of a photosensitizing dye adsorption device according to another embodiment of the present disclosure.

### DETAILED DESCRIPTION

Embodiments of the present disclosure will now be in detail described with reference to the accompanying drawings. Also, the disclosure below is given for the purpose of one embodiment only, and various example modes satisfying same physical and chemical conditions are within the scope of the present disclosure.

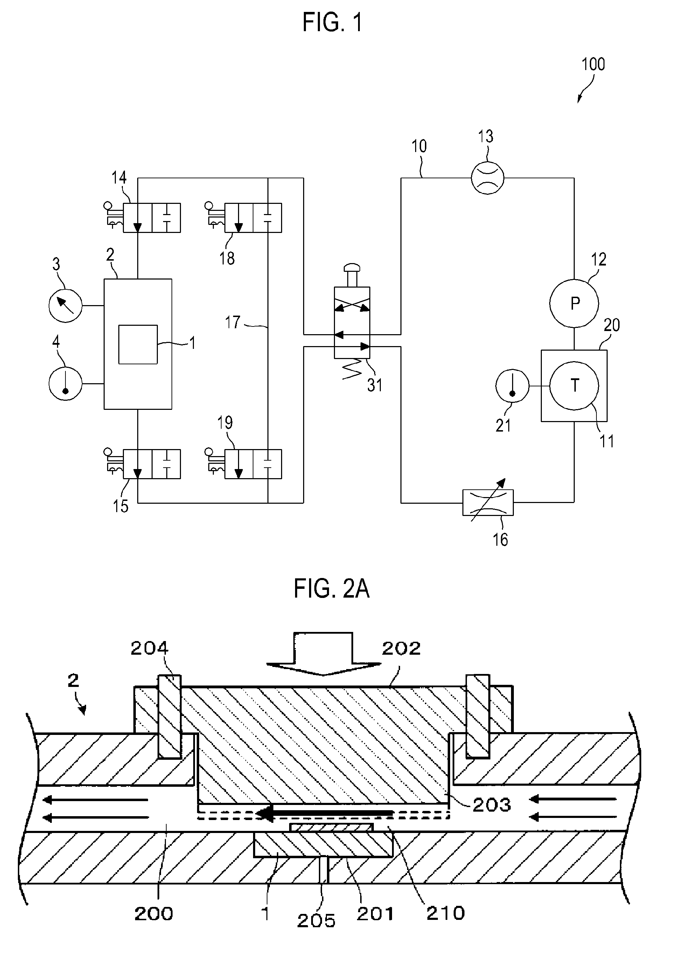

**FIG. 1** is a view schematically illustrating the overall configuration of a photosensitizing dye adsorption device 100 as an apparatus for manufacturing a dye-sensitized solar cell, according to one embodiment of the present disclosure. The photosensitizing dye adsorption device 100 includes a substrate housing part 2 configured to house a substrate 1, on which an electrode material layer acting as a working electrode of the dye-sensitized solar cell is formed.

The substrate housing part 2, which is formed in a sealing vessel shape, includes a pressure gauge 3 configured to measure the pressure of a photosensitizing dye solution within the substrate housing part 2, and a temperature gauge 4 configured to measure the temperature of the photosensitizing dye solution, so as to measure the pressure and temperature of the photosensitizing dye solution. A temperature adjusting bath (not shown) is disposed outside the substrate housing part 2 to adjust the temperature of the photosensitizing dye solution within the substrate housing part 2. Further, a circulation line 10, through which the photosensitizing dye solution is circulated, is connected to the substrate housing part 2.

In the circulation line 10, a tank 11 to accommodate the photosensitizing dye solution therein, a pump 12, a flowmeter 13, manual valves 14 and 15, a needle valve 16, and an inverting valve 31 are disposed. Further, a bypass line 17 which is branched from an upstream side of the substrate housing part 2 and is connected to a downstream side thereof, is disposed in the circulation line 10. Manual valves 18 and 19 are disposed in the bypass line 17. The bypass line 17, which is configured to circulate the photosensitizing dye solution by bypassing the substrate housing part 2, is used when loading/unloading the substrate 1 with the electrode material layer formed thereon into/from the substrate housing part 2. The circulation of the photosensitizing dye solution through the bypass line 17 prevents the photosensitizing dye solution from being circulated through the substrate housing part 2 while maintaining the circulation of the photosensitizing dye solution. This facilitates the replacement of a processed substrate 1 with a subsequent substrate 1 to be processed later, thereby speeding up the process of the subsequent substrate 1. The circulation of the photosensitizing dye solution through the substrate housing part 2 or the circulation of photosensitizing dye solution through the bypass line 17 while bypassing the substrate housing part 2 may be switched by operating the manual valves 14, 15, 18 and 19. The photosensitizing dye solution is deteriorated when exposed to light. For this reason, the circulation line 10 and the bypass line 17 are preferably formed of or covered with a light blocking member.

The inverting valve 31 is provided to invert the flow of the photosensitizing dye solution to the substrate 1. When the size of the substrate 1 is large, it is possible that the amount of the photosensitizing dye adsorbed on the electrode material layer of the substrate 1 is different between upstream and downstream sides of the flow of the photosensitizing dye solution. In other words, when a plurality of substrates 1 are loaded into the substrate housing part 2 for processing, the adsorption amount of the photosensitizing dye solution may be different between the substrate 1 loaded in the upstream side and the substrate 1 loaded in the downstream side. To address these concerns, the flow of the photosensitizing dye solution may be inverted by switching a flow path by the inverting valve 31 so that the photosensitizing dye is uniformly adsorbed.

The tank 11 configured to accommodate the photosensitizing dye solution therein is equipped with a temperature adjusting bath 20 configured to adjust the temperature of the photosensitizing dye solution within the tank 11, and a temperature gauge 21 configured to measure the temperature of the photosensitizing dye solution within the tank 11. The photosensitizing dye solution whose the temperature was adjusted by the temperature adjusting bath 20 is configured to be circulated through the substrate housing part 2 by the pump 12. When the temperature of the photosensitizing dye solution is changed while flowing from the tank 11 to the substrate housing part 2, the circulation line 10 may be made of a member having a high heat insulation property, or the circulation line 10 and the bypass line 17 may be covered with a heat insulting member.

A solution obtained by dissolving a photosensitizing dye in a solvent is used as the photosensitizing dye solution. Examples of the photosensitizing dye may include metal complex-based dyes including metals such as Ru and metal-free organic dyes. N3, N719 and black dye are often used as the Ru metal complex-based dye. Indoline-, xanthenes-, coumarin-, pherylene-, cyanine-, merocyanine-, polyene- and porphyrin-based dyes can be used as the organic dyes. Conventional organic solvents such as water, alcohol, acetonitrile, ethanol, toluene, dimethylformamide, tetrahydrofuran or the like can be used as the solvent for dissolving the photosensitizing dyes.

The concentration of the photosensitizing dye solution may be in the range of about 0.1 mM to 1 mM. In the photosensitizing dye solution, a low concentration causes an increased adsorption time, while a high concentration causes the association between photosensitizing dyes in particles on which the photosensitizing dyes are adsorbed. This association reduces photoelectric conversion efficiency. Also, the concentration of the photosensitizing dye solution is gradually decreased while performing a photosensitizing dye adsorption process to the substrate 1 with the electrode material layer formed thereon. On the other hand, the concentration of the photosensitizing dye solution is increased by the evaporation of the solution. For this reason, monitoring the concentration of the photosensitizing dye solution is important. Therefore, a concentration measuring unit configured to measure the concentration of the photosensitizing dye solution may be disposed in the circulation line 10 or the tank 11, thereby monitoring a change in the concentration of the photosensitizing dye solution during the adsorption process.

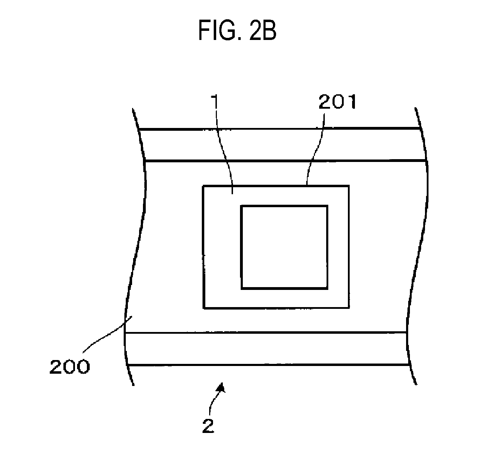

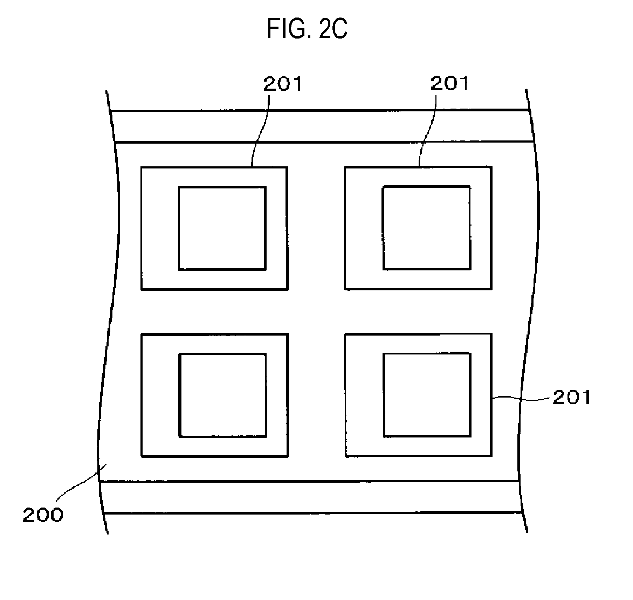

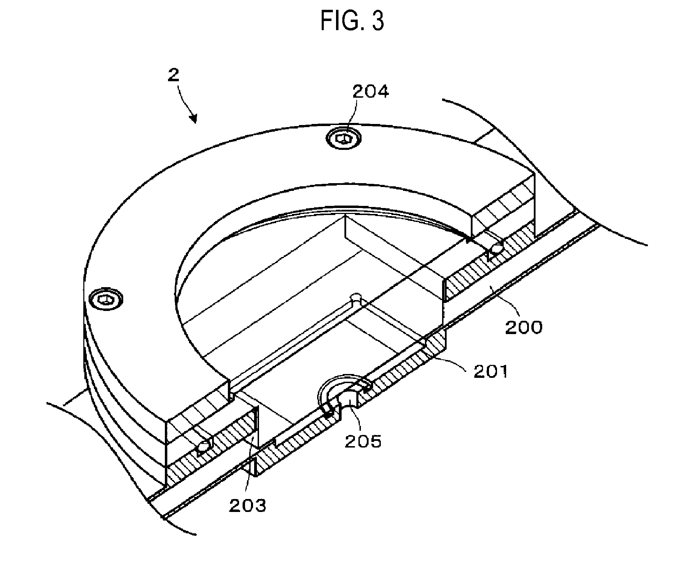

**FIG. 2** is a view schematically showing a longitudinal cross sectional configuration **(****FIG. 2A****)** and a traversal cross sectional configuration **(****FIG. 2B****)** of the substrate housing part 2, and **FIG. 3** is a perspective view schematically showing the configuration of a top plane of the substrate housing part 2 which is cut in half. As shown in **FIG. 2****,** the substrate housing part 2 includes a flow path 200 having a rectangular cross section through which the photosensitizing dye solution flows. A central portion which is substantially in the flow path 200 is caved in a rectangular shape in conformity to an outer shape of the substrate 1, which constitutes a recess 201 to receive the substrate 1. An absorption mechanism 205 configured to fix the substrate 1 is disposed in the recess 201.

Further, a lid member 202 is disposed in a ceiling portion of the flow path 200 which faces the recess 201. A protrusion 203, which protrudes in a rectangular shape in conformity to the shape of the flow path 200, is disposed in a lower side of the lid member 202. Further, the photosensitizing dye solution flows through a flow path 210, which is formed between the protrusion 203 and the substrate 1, at a section which faces the surface of the substrate 1. The cross sectional area of the flow path 210 at the section facing the surface of the substrate 1 is configured to be narrower (i.e., smaller) than that of the flow path 210 at the other sections. The lid member 202 and the protrusion 203 are configured to be detachably mounted by using a plurality of (four in this embodiment) screws 204 so that the lid member 202 may be replaced with another lid member 202 having a protrusion 203 with a different projection height, thereby changing the cross sectional area of the flow path 210 at the section facing the surface of the substrate 1.

Further, since the photosensitizing dye solution is deteriorated when exposed to light, the lid member 202 and the protrusion 203 are preferably made of a light blocking member. However, in this embodiment, the lid member 202 and the protrusion 203 are made of a transparent acryl. With this configuration, the lid member 202 and the protrusion 203 can be used as an observation window through which an operator observes the inside of the substrate housing part 2. In this case, when the operator does not want to observe the inside of the substrate housing part 2, the lid member 202 may be preferably covered with a light blocking member.

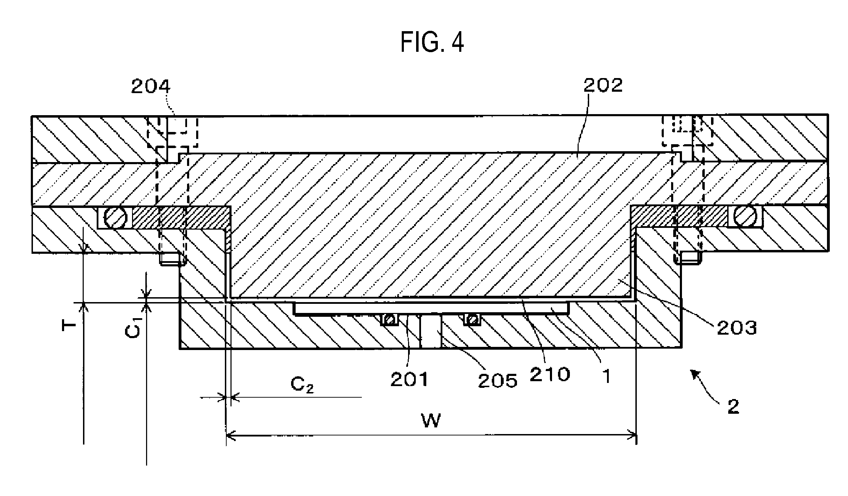

**FIG. 4** is a view showing an example of a cross section configuration of the flow path 210. In this example, a width W of the flow path 210 is 90 mm, a height T thereof is 10 mm, a distance C₁ between the lower surface of the protrusion 203 and the top surface of the substrate 1 is about 1 mm, and a distance C₂ between a side surface of the protrusion 203 and a side wall of the flow path 200 is about 1 mm. In this case, a cross sectional area of the flow path 210 is 108 mm².

In the photosensitizing dye adsorption device 100 configured as above, the electrode material layer acting as the working electrode of the dye-sensitized solar cell is formed on the substrate 1, which is loaded into the substrate housing part 2. The temperature of the photosensitizing dye solution is adjusted to a predetermined temperature within the tank 11, and the photosensitizing dye solution is circulated by driving the pump 12 with the manual valves 14 and 15 opened and with the manual valves 18 and 19 closed, thereby allowing the photosensitizing dye to be adsorbed to the electrode material layer of the substrate 1. At the same time, the cross sectional area of the flow path 210 may be set to be small, which will provide an efficient adsorption of a required amount of the photosensitizing dye to the electrode material layer of the substrate 1 in a short time. This is due to the fact that the photosensitizing dye solution can be easily infiltrated to the porous metal oxide semiconductor layer by raising the pressure of the photosensitizing dye solution flowing through the flow path 210, and an amount of the photosensitizing dye per unit time to be contacted to particles of the porous metal oxide semiconductor layer can be increased by raising a flow speed of the photosensitizing dye solution flowing through the flow path 210. After the photosensitizing dye is adsorbed to the electrode material layer formed on the substrate 1 by the photosensitizing dye adsorption device 100, the substrate 1 and the counter electrode are engaged, electrolytic is injected therebetween, and a sealing process is performed. As such, it is possible to obtain the dye-sensitized solar cell.

Further, although this embodiment illustrates that the cross sectional area of the flow path 210 has been described to be changed by the detachable lid member 202 with the protrusion 203 formed thereon, in some embodiments, the side wall of the flow path 210 may be formed to be interiorly protruded such that the cross sectional area of the flow path 210 is smaller than that of the flow path 200. Alternatively, a detachable substrate loading part with a protrusion formed thereon may be used. On the other hand, the cross sectional area of the flow path 210 may be set to be smaller than that of the flow path 200 by locating the substrate 1 near an wall surface of the flow path 210 by way of a vertically-movable substrate loading table. Alternatively, the cross sectional area of the flow path 210 may be set to be smaller than that of the flow path 200 by installing a movable member acting to narrow the flow path 210 in the wall surface (e.g., the side wall) of the flow path 210.

In some embodiments, a plurality of substrates 1 may be housed within the substrate housing part 2. As shown in **FIG. 2C****,** a plurality of recesses 201 may be formed and the plurality of substrates 1 are housed within respective recesses of the plurality of recesses 201, which makes it possible to further increase the speed of the production process of the dye-sensitized solar cell at a low cost.

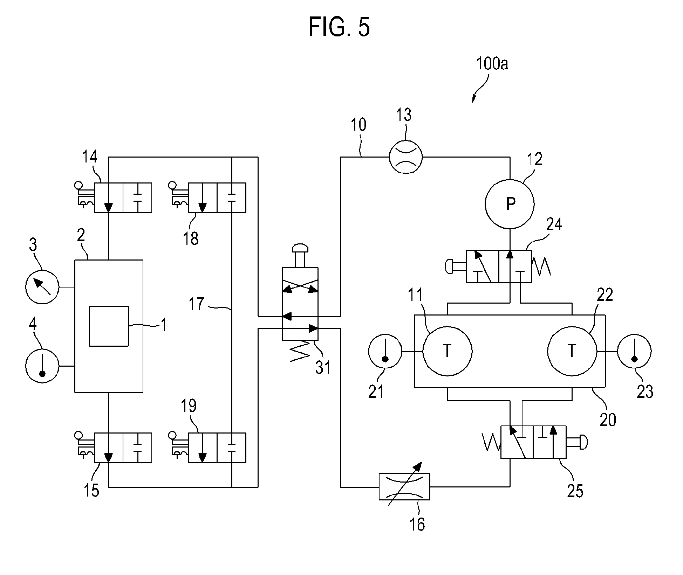

A description will now be made as to a photosensitizing dye adsorption device 100a according to another embodiment of the present disclosure with reference to **FIG. 5****.** To produce a dye-sensitized solar cell having high conversion efficiency, a rinse process is required for washing away remaining photosensitizing dyes which was not used for the photoelectric conversion after the adsorption of the photosensitizing dye. In this embodiment, the temperature adjusting bath 20 is provided with a rinse tank 22 to accommodate a rinse solution therein, in addition to the tank 11 to accommodate the photosensitizing dye solution therein. Conventional organic solvents such as water, alcohol, acetonitrile, toluene, dimethylformamide, tetrahydrofuran or the like can be used as the rinse solution. Preferably, the same solution as the solvent for dissolving the photosensitizing dyes may be used as the rinse solution. Further, a temperature gauge 23 configured to measure the temperature of the rinse solution is installed in the rinse tank 22.

Further, switching valves 24 and 25 are installed in outlet and inlet sides of the tank 11 and the rinse tank 22 of the circulation line 10, respectively, such that liquid circulating through the circulation line 10 is turned to the photosensitizing dye solution or the rinse solution. With this configuration, the photosensitizing dye solution is firstly circulated and the photosensitizing dye is adsorbed to the substrate 1, followed by circulating the rinse solution to perform the rinse process. The other parts have the same configuration as that in the photosensitizing dye adsorption device 100 shown in **FIG. 1****,** and the same reference numerals indicate the same or similar elements, and therefore, a description thereof is omitted herein.

The photosensitizing dye adsorption device as described above can perform the adsorption process of the photosensitizing dye in the production of the working electrode of the dye-sensitized solar cell, and subsequently the rinse process which is required for the production of the dye-sensitized solar cell having high conversion efficiency. Specifically, the photosensitizing dye adsorption device can be used as an apparatus which performs the rinse process in the dye-sensitized solar cell manufacturing apparatus. Since the rinse process can be performed after the adsorption process of the photosensitizing dye without discharging the substrate 1 from the dye-sensitized solar cell manufacturing apparatus, it is possible to further increase the speed of the production process of the dye-sensitized solar cell having high conversion efficiency.

### (Examples)

The following is a description of examples of the present disclosure. An FTO thin film made by doping fluorine on tin oxide having a size of 60mm×70mm×3mm was formed on a glass substrate (Nippon Sheet Glass, 9 to 10 Ω/□). Thereafter, a porous titanium oxide thin film is formed on the FTO thin film of the FTO film glass substrate. The titanium oxide is a commercially available titanium oxide paste Ti-NanoxideD/SP (SOLARONIX). The paste is applied on the FTO thin film of the FTO film glass substrate in the area of 50 mm × 50 mm (at the time of evaluation of a dye adsorption amount, which will be described later) or in the area of 5 mm × 5 mm (at the time of characteristic evaluation, which will be described later) by way of a screen printing method, followed by sintering in an electric furnace at a temperature of 500 degrees C so as to have a film thickness of 8 *µ*m ± 0.5 *µ*m.

A material obtained by dissolving a dye (Ruthenium (Ru) organic complex N719, manufactured by DYESOL Co., cis-bis(isothiocyanate)bis(2,2'-bipyridyl-4,4'-dicarboxylato)-ruthenium(II) bis-tetrabutylammonium) in ethanol at a concentration of 0.3 mM, was used as a solution for adsorbing dye on the porous titanium oxide thin film which is the working electrode. After the dye adsorption is performed by the photosensitizing dye adsorption device 100 configured as above, the substrate is extracted from the photosensitizing dye adsorption device 100, followed by dipping in ethanol under a static state for 15 minutes. Then, the substrate is then rinsed with the ethanol to remove the remaining dyes attached to the whole substrate including the working electrode. Thereafter, the substrate is dried, and 100 ml of 0.1 M aqueous sodium hydroxide solution was put into a beaker and the dyed porous titanium oxide film was immersed therein to completely dissolve the dye. Next, 3 ml of the solution was put into a quartz glass cell, and then the absorptivity of the solution was measured by a spectrophotometer to evaluate an adsorption amount.

An electrolyte solution was obtained by dissolving 0.05 M I₂ (iodine), 0.5M LiI (lithium iodide), 0.58M tBP (tertiary butyl pyridine) and 0.6M DMPII (ionic solution) in MeCN (acetonitrile).

A platinum catalyst of a counter electrode is deposited on an ITO film formed on a glass substrate with a thickness of about 10 nm by way of sputtering. The counter electrode was engaged with the working electrode by using an adhesive consisting of an ionomer resin of a thermoplastic sheet form, followed by heat-compression at 100 degrees C. Then, the electrode solution was injected in the engaged cell and it is sealed to obtain a photoelectric conversion device.

The photoelectric conversion device produced as above is the dye-sensitized solar cell, and the characteristics of the dye-sensitized solar cell were evaluated by using AM1.5 solar stimulator as a light source. The production conditions of the photoelectric conversion device and the results (efficiency, Voc, Jsc and FF) of I-V measurements are shown in the following Tables.

First, a description will be given as to the results obtained by measuring the relationship between the distance C₁ between the lower surface of the protrusion 203 and the top surface of the substrate 1 and an adsorption amount of the dye by way of the photosensitizing dye adsorption device 100 configured as above. The measurement was performed for the cases that the distance C₁ is 1 mm (flow path area = 108 mm²), and 5 mm (flow path area = 460 mm²), respectively. In each of the cases, a flow rate of the photosensitizing dye solution was 27000 mm³/s, 54000 mm³/s, 86400 mm³/s, or 108000 mm³/s, and a dipping time was 15 minutes, 30 minutes or 45 minutes. Further, the temperature of the photosensitizing dye solution was 30 degrees C. The results are shown in Table 1.

**[Table 1]**

| Conditions | Distance in top portion of substrate (mm) | Width of Flow path (mm) | Flow path area (mm²) | Flow speed in top portion of substrate (mm/s) | Flow rate (mm³/s) | Pressure (kPa):meaurements | Temperature (degrees C) | Concentration (mM) | Absorption amount to Dipping time (minute) [(nmol/cm²)/um] | | |
|---|---|---|---|---|---|---|---|---|---|---|---|
| | | | | | | | | | 15 minutes | 30 minutes | 45 minutes |
| 1-① | 1 | 90 | 108 | 250 | 27000 | 2.3 ∼ 3.2 | 30 | 0.3 | 7.09 | 9.81 | 11.26 |
| 1-② | 1 | 90 | 108 | 500 | 54000 | 6.5 ∼7.0 | 30 | 0.3 | 7.02 | 10.35 | 11.47 |
| 1-③ | 1 | 90 | 108 | 800 | 86400 | 14.0 ∼ 16.0 | 30 | 0.3 | - | 11.71 | - |
| 1-④ | 1 | 90 | 108 | 1000 | 108000 . | 19.6 ∼ 25.5 | 30 | 0.3 | 9.41 | 12.91 | 13.51 |
| 5-① | 5 | 90 | 460 | 59 | 27000 | 0.9 ∼ 1.8 | 30 | 0.3 | 4.64 | 7.78 | 9.76 |
| 5-② | 5 | 90 | 460 | 117 | 54000 | 5.3 ∼ 7.3 | 30 | 0.3 | 4.8 | 8.47 | 10.11 |
| 5-③ | 5 | 90 | 460 | 188 | 86400 | 11.9 ∼ 13.0 | 30 | 0.3 | 5.55 | 8.87 | 12.15 |
| 5-④ | 5 | 90 | 460 | 235 | 108000 | 18.5 ∼ 20.1 | 30 | 0.3 | 6.1 | 9.12 | 11.57 |

In the dye-sensitized solar cell, an adsorption amount of the photosensitizing dye is preferably at least about 80 (nmol/cm²) /µm or higher. In the case that the adsorption was performed in the static state of the solution at room temperature in the air, it takes at least about 5 to 6 hours so as to obtain such an adsorption amount.

Further, as shown in the above Table 1, whether the distance C₁ is 1 mm or 5 mm, the aforementioned adsorption amount may be obtained in about 30 minutes. Further, when the distance C₁ was 1 mm, it has been observed that a high adsorption amount is obtained in a short time as compared with the distance C₁ = 5 mm. For example, when the flow rate was 108000 mm³/s and the distance C₁ was 1 mm, the adsorption amount was 9.41 (nmol/cm²)/µm for 15 minutes, which is larger than the case that the adsorption amount was 9.12 (nmol/cm²)/µm for 30 minutes under the conditions of the same flow rate and the distance C₁ = 5 mm. Therefore, it is possible to obtain a necessary adsorption amount in a relatively short period of time by narrowing the distance C₁. In this case, the distance C₁ is preferably 5 mm or lower, more preferably, 1 mm or lower. As described above, it is possible to efficiently adsorb the photosensitizing dye in a short time by decreasing the cross sectional area of the flow path through which the photosensitizing dye solution is flowed (by narrowing the distance C₁) at the section which faces the surface of the substrate 1.

Next, a description will be given as to the results obtained by checking a progress on a rinse process using a rinse solution after the adsorption of the photosensitizing dye as described above, by way of the photosensitizing dye adsorption device 100a as shown in **FIG. 5****.** The adsorption of the photosensitizing dye was performed by forming the porous titanium oxide thin film having a size of 5 mm×5 mm as described above by way of the photosensitizing dye adsorption device 100. The adsorption of the dye was performed under the conditions that the distance C₁ is 1 mm, the flow rate of the photosensitizing dye solution is 108000 mm³/s, the dipping time is 60 minutes, and the temperature of the photosensitizing dye solution is 30 degrees C. After the adsorption of the dye, a substrate is extracted from the photosensitizing dye adsorption device 100, and characteristics of a cell, which is prepared by dipping in ethanol of a static state for 1 minute or 15 minutes and rinsing with the ethanol, were measured. The measurement results are shown in Table 2. A conversion efficiency of the cell was 5.3 % and 5.7 %, respectively. Also, after the adsorption of the dye was performed under the same conditions by the photosensitizing dye adsorption device 100a, characteristics of a cell, which is prepared by rinsing with the ethanol for 1 minute, were measured for the case of the distance C₁= 1 mm and the flow rate of the rinse solution = 27000 mm³/s. The measurement results are shown in Table 2. A conversion efficiency of the cell was 5.7 %. Specifically, after the adsorption of the photosensitizing dye was performed by way of the photosensitizing dye adsorption device 100a as shown in **FIG. 5****,** the rinse solution was circulated and the rinse process was performed for 1 minute like the adsorption process of the photosensitizing dye, thereby making it possible to obtain the same characteristics as the case of dipping in ethanol of a static state for 15 minutes and rinsing with the ethanol, wherein the characteristics were higher than that of the case of dipping in ethanol of a static state for 1 minute and rinsing with the ethanol. Accordingly, it was possible to efficiently perform the rinse process on the photosensitizing dye in a short time.

**[Table 2]**

| Rinse Conditions | Jsc [mA/cm²] | Voc [mV] | F.F | Efficiency (%) |
|---|---|---|---|---|
| EtOH dipping (for 15 minutes) | 12.4 | 660 | 0.696 | 5.7 |
| EtOH dipping (for 1 minute) | 11.2 | 670 | 0.706 | 5.3 |
| 1-① (for 1 minute) | 11.8 | 685 | 0.705 | 5.7 |

As described above, according to the embodiments of the present disclosure, it is possible to provide an apparatus and method for manufacturing a dye-sensitized solar cell, which can speed up a production process of a dye-sensitized solar cell at a low production cost, and enhance a photoelectric conversion efficiency of the dye-sensitized solar cell produced in a system comprising a dye adsorption process. Also, although the present disclosure have been described by embodiments and examples, these embodiments and examples are not intended to limit the scope of the present disclosure, and a variety of changes may be encompassed in the present disclosure.

### INDUSTRIAL USE OF THE PRESENT DISCLOSURE

The apparatus and method of manufacturing the dye-sensitized solar cell according to the present disclosure can be effective in the preparation of a dye-sensitized solar cell, and thus has industrial applicability.

### EXPLANATION OF REFERENCE NUMERALS

1: substrate, 2: substrate housing part, 3: pressure gauge, 4: temperature gauge, 10; circulation line, 11: tank, 12: pump, 13: flowmeter, 14, 15: manual valve, 16: needle valve, 17: bypass line, 18, 19: manual valve, 20: temperature adjusting bath, 21: temperature gauge, 31: inverting valve

## Claims

1. An apparatus for manufacturing a dye-sensitized solar cell configured for a photosensitizing dye solution to come in contact with an electrode material layer that functions as a working electrode of the dye-sensitized solar cell, and configured for a photosensitizing dye to be adsorbed by the electrode material layer, the apparatus comprising:
a substrate housing part formed in a sealing vessel shape and configured to house a substrate with the electrode material layer formed on the surface thereof; and
a circulation mechanism configured to circulate the photosensitizing dye solution for the photosensitizing dye solution to pass over the surface of the substrate housed within the substrate housing part,
wherein the photosensitizing dye solution is flowed through a cross sectional area of a flow path at a section that faces the substrate housed within the substrate housing part, and the cross sectional area of a flow path is configured to be smaller than cross sectional areas of the flow path through which the photosensitizing dye solution is flowed at the other sections.

2. The apparatus of Claim 1, wherein a detachable protrusion which protrudes toward the inside of the flow path is formed at a section which faces the substrate housed within the substrate housing part, and
wherein the cross sectional area of the flow path is changed by changing the protrusion.

3. The apparatus of Claim 1 or 2, wherein a plurality of substrates are loaded into the substrate housing part.

4. The apparatus of any one of Claims 1 to 3, comprising an inverting mechanism configured to invert a flow of the photosensitizing dye solution.

5. The apparatus of any one of Claims 1 to 4, comprising a temperature adjusting mechanism configured to adjust the temperature of the photosensitizing dye solution.

6. The apparatus of any one of Claims 1 to 5, comprising a flow rate control mechanism configured to control the flow rate of the photosensitizing dye solution.

7. The apparatus of any one of Claims 1 to 6, comprising a concentration measurement mechanism configured to detect a concentration of the photosensitizing dye solution.

8. The apparatus of any one of Claims 1 to 7, comprising a rinse solution tank to accommodate a rinse solution for rinsing the photosensitizing dye therein,
wherein the rinse solution is circulated through the substrate housing part by switching the photosensitizing dye solution to the rinse solution.

9. The apparatus of Claim 8, comprising a temperature control mechanism configured to control the temperature of the rinse solution.

10. The apparatus of Claim 8 or 9, comprising a flow rate control mechanism configured to control the flow rate of the rinse solution.

11. A method for manufacturing a dye-sensitized solar cell configured for a photosensitizing dye solution to come in contact with an electrode material layer that functions as a working electrode of the dye-sensitized solar cell, and configured for a photosensitizing dye to be adsorbed by the electrode material layer, the method comprising:
housing, via a substrate housing part formed in a sealing vessel shape, a substrate with the electrode material layer formed on the surface thereof; and
circulating the photosensitizing dye solution through a flow path which is formed between the surface of the substrate housed within the substrate housing part and a facing surface of the substrate housing part which faces the surface of the substrate.

12. The method of Claim 11, wherein the flow path is formed such that a distance between the surface of the substrate and the facing surface of the substrate housing part is 5 mm or lower.

13. The method of Claim 11, wherein the flow path is formed such that the distance between the surface of the substrate and the facing surface of the substrate housing part is 1 mm or lower.

14. The method of any one of Claims 11 to 13, wherein the electrode material layer is a porous metal oxide semiconductor layer.

15. The method of any one of Claims 11 to 14, wherein the photosensitizing dye is a Ru metal complex-based dye or organic dyes.

16. The method of any one of Claims 11 to 15, wherein a concentration of the photosensitizing dye in the photosensitizing dye solution is in the range of 0.1 mM to 1 mM.

17. The method of any one of Claims 11 to 16, wherein a plurality of substrates are loaded in the substrate housing part.

18. The method of any one of Claims 11 to 17, wherein the flow of the photosensitizing dye solution is inverted.

19. The method of any one of Claims 11 to 18, wherein after the adsorption of the photosensitizing dye, a rinse process is performed without unloading the substrate from the substrate housing part.
